# EUROPEAN PATENT APPLICATION

(11) **EP 1 150 363 A2**
(43) Date of publication of application: **31.10.2001**
(21) Application number: 01109675.7
(22) Date of filing: 19.04.2001
(51) Int. Cl.: H01L 41/083, H01L 41/047

(54) **Multilayer piezoelectric actuator device having a conductive member attached to an external electrode thereof**

(30) Priority: 20.04.2000 JP 2000118920
(71) Applicant: TOKIN CERAMICS CORPORATION, Shiso-gun, Hyogo (JP)
(72) Inventor: Takao, Fumio, Shiso-gun, Hyogo (JP); Kosaka, Hideaki, Shiso-gun, Hyogo (JP); Ogura, Narumi, Shiso-gun, Hyogo (JP)
(74) Representative: Prüfer, Lutz H., Dipl.-Phys.

(57) **Abstract**

In a multilayer piezoelectric actuator device having a plurality of piezoelectric elements (1a) and a plurality of internal electrodes (1b) stacked in a stacking direction to form a multilayer structure (1) so that each of the internal electrodes is placed between adjacent ones of the internal electrodes. A pair of external electrodes (2) are disposed on a side surface of the multilayer structure and connected to adjacent ones of the internal electrodes, respectively. A pair of conductive members (3) are connected to the external electrodes, respectively. Each of the conductive member is spaced from and faced to the side surface of the multilayer structure.

## Description

### Background of the Invention

This invention relates to a multilayer piezoelectric actuator device in which a plurality of piezoelectric layers and a plurality of internal electrode layers are alternately stacked to form a multilayer structure so that each of the internal electrodes is placed between adjacent ones of the internal electrodes.

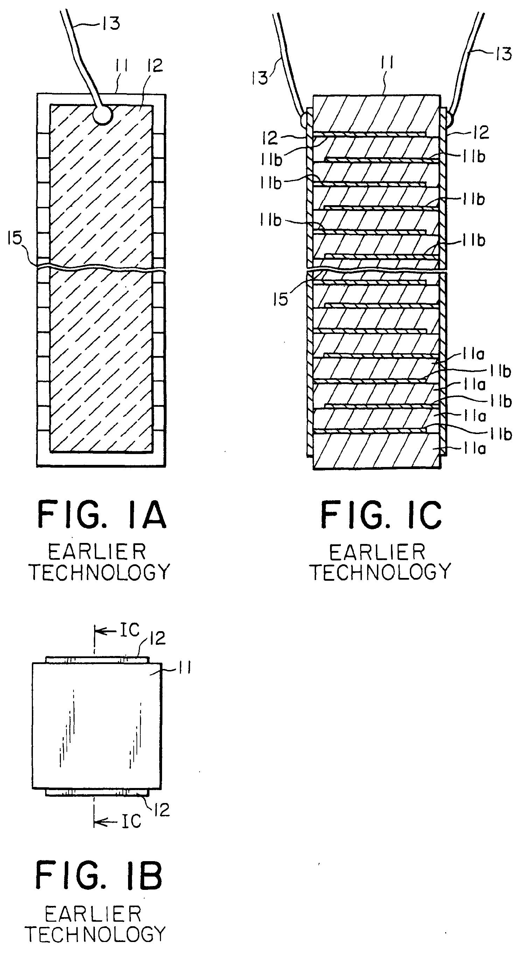

Referring to Figs. 1 A through 1C, a multilayer piezoelectric actuator device in earlier technology will be described. The multilayer piezoelectric actuator device being illustrated comprises a multilayer structure 11 including a plurality of piezoelectric ceramics layers 11a and a plurality of internal electrodes 11b alternately laminated or stacked in a vertical stacking direction. The multilayer structure 11 has a side surface provided with a pair of external electrodes 12. Specifically, the external electrodes 12 are fixed to a pair of side surface portions opposite to each other in a direction perpendicular to the stacking direction, respectively.

The external electrodes 12 are connected alternately to the internal electrodes 11b. Namely, adjacent ones of the internal electrodes 11b are connected to one and another of the external electrodes 12, respectively. Each of the external electrodes 12 may comprise a conductive member treated by firing of silver or deposition of gold. A pair of external lead wires 13 are connected to upper parts of the external electrodes 12, respectively.

In order to drive the piezoelectric actuator device mentioned above, the external lead wires 13 are applied with a pulsed voltage. When the pulsed voltage is applied, the multilayer piezoelectric actuator device repeats quick extension and contraction under the piezoelectric effect to provide a function as the actuator device.

In the multilayer piezoelectric actuator device illustrated in Figs. 1A through 1 C, repetition of such extension and contraction for a long period of time may result in occurrence of a crack 15 in the multilayer structure 11 and the external electrodes 12 due to fatigue. Sometimes, the external electrodes 12 will be torn off so that lower parts of the multilayer structure 11 below the crack 15 are no longer operable.

In addition, application of the pulsed voltage will induce internal heat in the multilayer piezoelectric actuator device to thereby elevate the device temperature.

### Summary of the Invention:

It is therefore an object of this invention to provide a multilayer piezoelectric actuator device capable of reducing the possibility of degradation in function even if it is driven for a long period of time.

It is another object of this invention to provide a multilayer piezoelectric actuator device capable of suppressing degradation in function even in occurrence of a crack in a multilayer structure and an external electrode.

It is still another object of this invention to provide a multilayer piezoelectric actuator device capable of suppressing an elevation in device temperature.

Other objects of the present invention will become clear as the description proceeds.

According to an aspect of this invention, there is provided a multilayer piezoelectric actuator device which comprises a multilayer structure including a plurality of piezoelectric elements and a plurality of internal electrodes, the piezoelectric elements and the internal electrodes being stacked in a stacking direction so that each of the internal electrodes is placed between adjacent ones of the internal electrodes, a pair of external electrodes disposed on a side surface of the multilayer structure, the external electrodes being connected to adjacent ones of the internal electrodes, respectively, and a pair of conductive members connected to the external electrodes, respectively, each of the conductive member being spaced from and faced to the side surface of the multilayer structure.

According to another aspect of this invention, there is provided a multilayer piezoelectric actuator device which comprises a multilayer structure including a plurality of piezoelectric elements and a plurality of internal electrodes, the piezoelectric elements and the internal electrodes being stacked in a stacking direction so that each of the internal electrodes is placed between adjacent ones of the internal electrodes, a pair of external electrodes disposed on a side surface of the multilayer structure, the external electrodes being connected to adjacent ones of the internal electrodes, respectively, and a pair of conductive members connected to the external electrodes, respectively, each of the conductive member being spaced from and faced to the side surface of the multilayer structure, the side surface of the multilayer structure having a pair of side surface portions opposite to each other in a direction perpendicular to the stacking direction, the external electrodes being fixed to the side surface portions, respectively, the internal electrodes being alternately exposed on the side surface portions and connected to the external electrodes, respectively, each of the internal electrodes having an end face which is substantially flush with one of the side surface portions and is retracted from another of the side surface portions.

According to still another aspect of this invention, there is provided a multilayer piezoelectric actuator device which comprises a multilayer structure including a plurality of piezoelectric elements and a plurality of internal electrodes, the piezoelectric elements and the internal electrodes being stacked in a stacking direction so that each of the internal electrodes is placed between adjacent ones of the internal electrodes, a pair of external electrodes disposed on a side surface of the multilayer structure, the external electrodes being connected to adjacent ones of the internal electrodes, respectively, and a pair of conductive members connected to the external electrodes, respectively, each of the conductive member being spaced from and faced to the side surface of the multilayer structure, the side surface of the multilayer structure having a pair of side surface portions opposite to each other in a direction perpendicular to the stacking direction, the external electrodes being fixed to the side surface portions, respectively, the internal electrodes being alternately exposed on the side surface portions and connected to the external electrodes, respectively, each of the internal electrodes having an end face which is substantially flush with the side surface portions and covered with an insulator only at one of the side surface portions.

### Brief Description of the Drawing:

Figs. 1A through 1C show an existing multilayer piezoelectric actuator device, Fig. 1A being a front view, Fig. 1B being a bottom view, Fig. 1C being a sectional view taken along a line IC-IC in Fig. 1 B;
Figs. 2A through 2C show a multilayer piezoelectric actuator device according to a first embodiment of this invention, Fig. 2A being a front view, Fig. 2B being a bottom view, Fig. 2C being a sectional view taken along a line IIC-IIC in Fig. 2B; and
Figs. 3A through 3C show a multilayer piezoelectric actuator device according to a second embodiment of this invention, Fig. 3A being a front view, Fig. 3B being a bottom view, Fig. 3C being a sectional view taken along a line IIC-IIC in Fig. 3B.

### Description of the Preferred Embodiments:

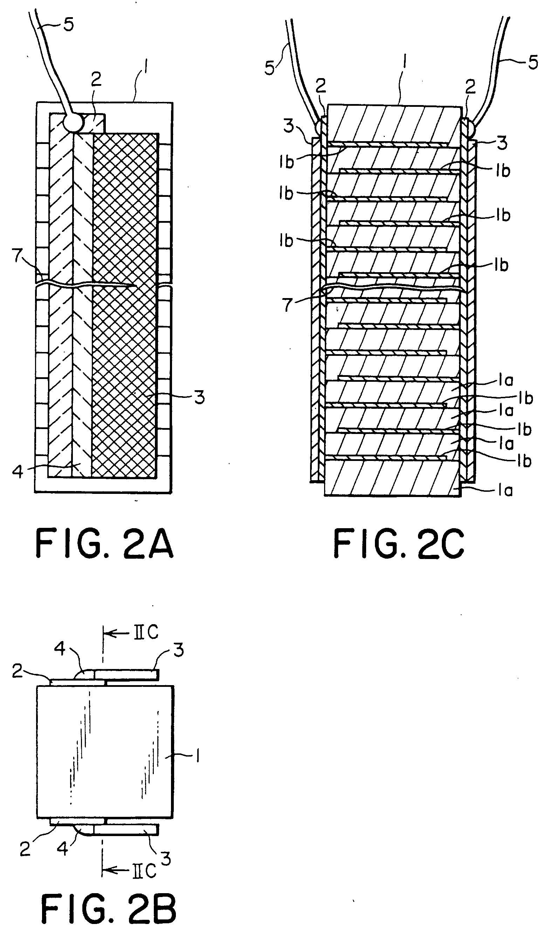

Referring to Figs. 2A through 2C, description will be made about a multilayer piezoelectric actuator device according to a first embodiment of this invention.

The multilayer piezoelectric actuator device being illustrated comprises a multilayer structure 1 including a plurality of piezoelectric ceramics layers 1a and a plurality of internal electrodes 1b alternately laminated or stacked in a vertical stacking direction. The multilayer structure 1 has a side surface provided with a pair of external electrodes 2. Specifically, the external electrodes 2 are fixed to a pair of side surface portions opposite to each other in a direction perpendicular to the stacking direction, respectively. For example, each of the piezoelectric layers 1a is made of a piezoelectric ceramics material.

The internal electrodes 1 b are alternately exposed at one and another of the side surface portions of the multilayer structure 1. More particularly, odd-numbered ones of the internal electrodes 1b as counted from the lowermost one have one end faces substantially flush with and exposed on a left side surface of the multilayer structure 1 in Fig. 2C. On the other hand, even-numbered ones of the internal electrodes 1b have one end faces substantially flush with and exposed on a right side surface of the multilayer structure 1 in Fig. 2C. It is to be noted that the opposite end of each of the terminal electrodes 2 is retracted from the surface of the multilayer structure 1.

Each of the external electrodes 2 is of a plate-like shape extending long in the above-mentioned stacking direction. The external electrodes 2 are connected alternately to the internal electrodes 1b on the side surface portions of the multilayer structure 1. Namely, adjacent ones of the internal electrodes 1b are connected to one and another of the external electrodes 2, respectively. Each of the external electrodes 2 may comprise a conductive member treated by firing of silver or deposition of gold.

The external electrodes 2 extend in the stacking direction of the multilayer structure 1 and fixedly attached to the one side surface portion and the other side surface portion of the multilayer structure 1, respectively. Therefore, the external electrode 2 formed on the one side surface portion of the multilayer structure 1 is electrically connected to the odd-numbered ones of the internal electrodes 1b while the external electrode 2 formed on the other side surface portion of the multilayer structure 1 is electrically connected to the even-numbered ones of the internal electrodes 1b. A pair of external lead wires 5 are connected by soldering to upper parts of the external electrodes 2, respectively.

The multilayer piezoelectric actuator device further comprises a pair of conductive members 3 coupled to the external electrodes 2, respectively. Each of the conductive members 3 is made of a metal foil such as a copper foil and extends in the stacking direction to be spaced from and faced to the side surface of the multilayer structure 3. Each of the conductive members 3 is slightly shorter than the external electrode 2 in the stacking direction.

The conductive member 3 has one transversal end electrically and mechanically connected to the external electrode 2 by a brazing metal 4. On the other hand, the other transversal end of the conductive member 3 is not connected to anywhere at all and is a free end independent of the external electrode 2 and the multilayer structure 1.

It will be assumed here that a crack 7 is produced in the multilayer structure 1 and the external electrodes 2 due to some reason. In this event, the transversal one end of the conductive member 3 may be torn off together with the external electrode 2. However, the other transversal end of the conductive member 3 is not subjected to any force and is therefore kept undamaged without being torn off. As a consequence, upper and lower segments of the external electrode 2 split by the crack 7 are electrically connected by the other transversal end of the conductive member 3 so as to keep electrical connection of all of the internal electrode1b. Thus, the multilayer piezoelectric actuator device is prevented from degradation in function.

Next, description will be made of a method of producing the piezoelectric ceramics actuator device illustrated in Figs. 2A through 2C. at first, preparation is made of the multilayer structure 1 having a sectional size of 5mm square and a length of 60mm. In the multilayer structure 1, the internal electrodes 1 b are alternately exposed on the one and the other side surface portions. On the both side surface portions of the multilayer structure 1, the external electrodes 2 having a width of 2mm and a length of 55mm are formed by screen printing and firing a silver paste. Then, preparation is made of the conductive member 3 of a copper foil having a width of 4mm, a length of 50mm, and a thickness of 50µm. The one transversal end of the conductive member 3 is continuously attached by brazing to the external electrode 2. At this time, the other transversal end of the conductive member 3 is not connected to the external electrode 2. Finally, the external lead wire 5 is connected to one end of the external electrode 2.

The multilayer piezoelectric actuator device illustrated in Figs. 2A through 2C and the multilayer piezoelectric actuator device illustrated in Figs. 1A through 1 C were driven 10⁹ times by supplying a rectangular wave signal of 0-150V and 1 kHz. In this event, in the multilayer piezoelectric actuator device illustrated in Figs. 1 A through 1C, the external electrodes 12 were completely torn off by the crack 15 to cause current interruption. Therefore, the lower part of the multilayer structure 11 below the crack 15 was no longer operable.

On the other hand, also in the multilayer piezoelectric actuator device illustrated in Figs. 2A through 2C, brazed portions of the external electrodes 2 or the conductive members 3 were torn off by the crack 7. However, the multilayer piezoelectric actuator device is never degraded in function. This is because the conductive member 3 has an unconnected part not connected to the external electrode 2 by brazing and keeps electrical connection by the unconnected part that is prevented from being torn off.

As described above, it is understood that the multilayer piezoelectric actuator device illustrated in Figs. 2A through 2C is improved in durability and in reliability as compared with the multilayer piezoelectric actuator device illustrated in Figs. 1A through 1C. Furthermore, by connecting the conductive member 3 to the external electrode 2, the surface area of the actuator device is increased and the conductive member 3 serves as a heat sink to suppress the temperature elevation of the multilayer piezoelectric actuator device.

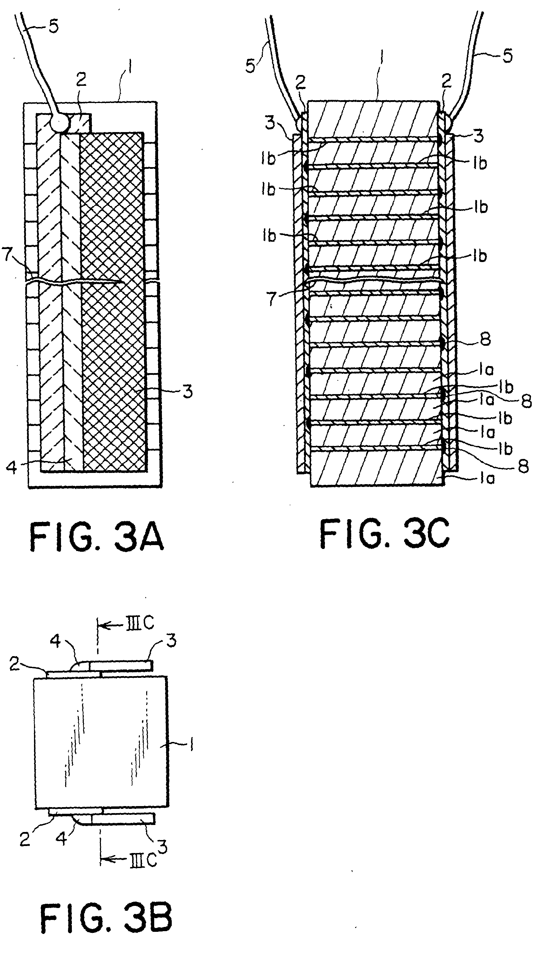

Next referring to Figs. 3A through 3C, description will be made of a multilayer piezoelectric actuator device according to a second embodiment of this invention. Similar parts are designated by like reference numerals and description will be omitted.

In the multilayer piezoelectric actuator device being illustrated, each of all internal electrodes 1 b have opposite ends which are substantially flush with the opposite side surface portions of the multilayer structure 1, respectively. However, on each of the opposite side surface portions of the multilayer structure 1, the internal electrodes 1 b are alternately covered with insulating glass coatings 8 and alternately uncovered or exposed. Therefore, like in the multilayer piezoelectric actuator device illustrated in Figs. 2A through 2C, the external electrodes 2 are alternately connected to the internal electrodes 1b so that every second ones and the remaining ones of the internal electrodes 1b are connected to one and the other of the external electrodes 2 on the opposite side surface portions, respectively.

Each of the external electrodes 2 is coupled to the conductive member 3. The conductive member 3 comprises a metal foil such as a copper foil. The conductive members 3 are formed on the side surface of the multilayer structure 1 to be spaced from and opposite to each other and extend long in the stacking direction.

The multilayer piezoelectric actuator device illustrated in Figs. 3A through 3C also exhibits the effect equivalent to that achieved by the device illustrated in Figs. 2A through 2C.

As described above, in the multilayer piezoelectric actuator device according to this invention, degradation in function is suppressed even in occurrence of the crack in the multilayer structure and the external electrodes as a result of driving for a long period of time. In addition, it is possible to suppress the elevation of the device temperature.

## Claims

1. A multilayer piezoelectric actuator device which includes a multilayer structure (1) including a plurality of piezoelectric elements (1a) and a plurality of internal electrodes (1b), said piezoelectric elements and said internal electrodes being stacked in a stacking direction so that each of said internal electrodes is placed between adjacent ones of said internal electrodes, and a pair of external electrodes (2) disposed on a side surface of said multilayer structure, said external electrodes being connected to adjacent ones of said internal electrodes, respectively, **characterized by** further comprising a pair of conductive members (3) connected to said external electrodes, respectively, each of said conductive member being spaced from and faced to said side surface of the multilayer structure.

2. The multilayer piezoelectric actuator device according to claim 1, wherein each of said conductive members is made of a metal foil (3).

3. The multilayer piezoelectric actuator device according to claim 1 or 2, wherein said side surface of the multilayer structure has a pair of side surface portions opposite to each other in a direction perpendicular to said stacking direction, said external electrodes being fixed to said side surface portions, respectively.

4. The multilayer piezoelectric actuator device according to claim 3, wherein said internal electrodes are alternately exposed on said side surface portions and connected to said external electrodes, respectively.

5. The multilayer piezoelectric actuator device according to claim 4, wherein each of said internal electrodes has an end face which is substantially flush with one of said side surface portions and is retracted from another of said side surface portions.

6. The multilayer piezoelectric actuator device according to claim 4, wherein each of said internal electrodes has an end face which is substantially flush with said side surface portions and covered with an insulator (8) only at one of said side surface portions.

7. The multilayer piezoelectric actuator device according to any one of claims 1 through 6, wherein said conductive member has a function of a heat sink which promotes heat radiation.
